(19) Europäisches Patentamt European Patent Office Office européen des brevets

(11) **EP 1 297 575 B1**

(12) **EUROPÄISCHE PATENTSCHRIFT**

(45) Veröffentlichungstag und Bekanntmachung des Hinweises auf die Patenterteilung:
**28.03.2012 Patentblatt 2012/13**

(21) Anmeldenummer: **01942948.9**

(22) Anmeldetag: **04.07.2001**

(51) Int Cl.:
*H01L 29/06* (2006.01)    *H01L 29/36* (2006.01)
*H01L 21/331* (2006.01)

(86) Internationale Anmeldenummer:
**PCT/CH2001/000416**

(87) Internationale Veröffentlichungsnummer:
**WO 2002/003469 (10.01.2002 Gazette 2002/02)**

(54) **HALBLEITER LEISTUNGSBAUELEMENT UND VERFAHREN ZU SEINER HERSTELLUNG**

POWER SEMICONDUCTOR COMPONENT AND METHOD FOR PRODUCING THE SAME

COMPOSANT DE PUISSANCE A SEMI-CONDUCTEUR ET PROCEDE PERMETTANT DE LE PRODUIRE

(84) Benannte Vertragsstaaten:
**DE GB IT**

(30) Priorität: **04.07.2000 DE 10031781**

(43) Veröffentlichungstag der Anmeldung:
**02.04.2003 Patentblatt 2003/14**

(73) Patentinhaber: **ABB Schweiz AG
5400 Baden (CH)**

(72) Erfinder:
• **LINDER, Stefan
CH-4800 Zofingen (CH)**
• **ZELLER, Hans, Rudolf
CH-5242 Birr (CH)**

(74) Vertreter: **ABB Patent Attorneys
C/o ABB Schweiz AG
Intellectual Property (CH-LC/IP)
Brown Boveri Strasse 6
5400 Baden (CH)**

(56) Entgegenhaltungen:
**EP-A- 0 702 401    EP-A- 1 017 093
DE-A- 19 829 614**

• **PATENT ABSTRACTS OF JAPAN vol. 009, no. 310 (E-364), 6. Dezember 1985 (1985-12-06) -& JP 60 145660 A (MITSUBISHI DENKI KK), 1. August 1985 (1985-08-01)**
• **BURNS D ET AL: "NPT-IGBT - OPTIMIZING FOR MANUFACTURABILITY" PROCEEDINGS OF THE 8TH. INTERNATIONAL SYMPOSIUM ON POWER SEMICONDUCTOR DEVICES AND IC'S (ISPSD). MAUI, HAWAII, MAY 20 - 23, 1996, PROCEEDINGS OF THE INTERNATIONAL SYMPOSIUM ON POWER SEMICONDUCTOR DEVICES AND IC'S (ISPSD), NEW YORK, IEEE, US, Bd. SYMP. 8, 20. Mai 1996 (1996-05-20), Seiten 331-334, XP000598450 ISBN: 0-7803-3107-9 in der Anmeldung erwähnt**
• **YAMASHITA J ET AL: "A NOVEL EFFECTIVE SWITCHING LOSS ESTIMATION OF NON-PUNCHTHROUGH ANDPUCHNTROUGH IGBTS" ISPSD '97. 1997 IEEE INTERNATIONAL SYMPOSIUM ON POWER SEMICONDUCTOR DEVICES AND ICS. WEIMAR, MAY 26 - 29, 1997, IEEE INTERNATIONAL SYMPOSIUM ON POWER SEMICONDUCTOR DEVICES AND ICS, NEW YORK, NY: IEEE, US, Bd. CONF. 9, 26. Mai 1997 (1997-05-26), Seiten 109-112, XP000800169 ISBN: 0-7803-3994-0 in der Anmeldung erwähnt**

**Beschreibung**

**Technisches Gebiet**

Die Erfindung bezieht sich auf das Gebiet der Leistungselektronik. Sie bezieht sich auf ein Verfahren zur Herstellung eines Halbleiterbauelementes gemäss Oberbegriff des Patentanspruches 1 sowie auf ein Halbleiterelement gemäss Oberbegriff des Patentanspruches 5.

**Stand der Technik**

Um bestmögliche elektrische Charakteristika von Halbleiter-Leistungsschaltern, wie zum Beispiel eines IGBTs (Insulated Gate Bipolar Transistor) zu erzielen, muss die Dicke der aktiven Zone seines Halbleiterelementes so gering wie möglich gewählt werden.

Beispielsweise hat die Dicke einen direkten Einfluss auf die Durchlassverluste und die Lawinendurchbruchspannung. Im Falle von Durchbruchspannungen von 600 - 1800 V sind deshalb Dicken des Halbleiterelementes von 60-250 $\mu$m wünschenswert. Derartig geringe Dicken stellen jedoch in der Produktion der Halbleiterelemente ein grosses Problem dar, da Wafer mit einem Durchmesser von 100 mm und mehr eine Dicke von mindestens 300 $\mu$m aufweisen sollten, um die Bruchgefahr bei der Herstellung zu minimieren.

Im Stand der Technik wurde dieses Dickenproblem für Punch-Through-Leistungshalbleiber (PT) üblicherweise durch die sogenannte Epitaxiemethode gelöst. In dieser Methode wird auf einem Trägersubstrat mit einer relativ grossen Dicke von 400-600 $\mu$m eine elektrisch aktive Schicht gezüchtet. Dabei gilt die Regel, dass die aktive Schicht umso dicker sein muss, je höher die Spannungsfestigkeit des Halbleiterelementes ausfallen soll. Das Aufbringen dieser Schichten ist jedoch sehr zeitintensiv und teuer.

Für grössere Durchbruchspannungen wird im Stand der Technik vorzugsweise zwischen Trägerschicht und elektrisch aktiver Zone eine Stoppschicht, auch Buffer genannt, eingebracht. Diese Stoppschicht dient im Blockierfall dazu, das elektrische Feld abrupt vor der Anode abzubremsen-und damit von dieser fern zu halten, da, sollte das elektrische Feld die Anode erreichen, das Halbleiterelement zerstört werden kann. In Kombination mit einem transparenten Anodenemitter beeinflusst die Stoppschicht ferner die Injektionseffizienz des Anodenemitters. Ein Thyristor mit einer derartigen Stoppschicht und einem transparenten Anodenemitter ist in EP-A-0'700'095 beschrieben.

Zur Herstellung von Non-Punch-Through-Leistungshalbleitern (NPT) wird nicht die Epitaxiemethode, sondern ein Verfahren verwendet, wie es beispielsweise in Darryl Burns et al., NPT-IGBT-Optimizing for manufacturability, IEEE, Seite 109-112, 0-7803-3106-0/1996; Andreas Karl, IGBT Modules Reach New Levels of Efficiency, PCIM Europe, Issue 1/1998, Seite 8-12 und J. Yamashita et al., A novel effective switching loss estimation of non-punchthrough and punchthrough IGBTs, IEEE, Seite 331-334, 0-7803-3993-2/1997 beschrieben ist. Bei diesem Verfahren dient ein relativ dicker Wafer ohne Epitaxieschicht als Ausgangsmaterial. Typische Dicken liegen bei 400 - 600 $\mu$m. In einem ersten Schritt wird der Wafer kathodenseitig behandelt, das heisst, es werden Photolitographie, Ionenimplantation, Diffusionen, Ätzungen und sonstige für die Herstellung des Halbleiterelementes notwendigen Prozesse durchgeführt. In einem zweiten Schritt wird der Wafer auf der der Kathode entgegengesetzten Seite auf seine gewünschte Dicke reduziert. Dies erfolgt durch übliche Techniken, im allgemeinen durch Schleifen und Ätzen. In einem dritten Schritt wird nun auf dieser reduzierten Seite eine Anode eindiffundiert. Dieses Verfahren ist zwar kostengünstiger als die Epitaxiemethode, führt jedoch zu dickeren Halbleiterelementen.

DE-A-198 29 614 offenbart nun ein Herstellungverfahren für ein Leistungshalbleiterelement auf der Basis eines PT-Typs, welches die Herstellung relativ dünner Halbleiterelemente ermöglicht, ohne das Epitaxieverfahren anwenden zu müssen. Hierfür wird in eine niedrig dotierte Basiszone eine Stoppschicht mit einer grösseren Dicke als elektrisch erforderlich eingebracht, daraufhin Prozessschritte zur Ausführung einer kathodenseitigen strukturierten Oberfläche des Halbleiterelementes ausgeführt und erst anschliessend die Dicke der Stoppschicht durch Abschleifen und/oder Polieren auf die elektrisch notwendige Grösse verringert. Dadurch ist es möglich, die kathodenseitigen Prozessschritte an einem relativ dicken Wafer durchzuführen, so dass die Bruchgefahr verringert wird. Trotzdem lässt sich durch das anschliessende Verdünnen des Wafers ein Halbleiterelement schaffen, welches die gewünschte geringe Dicke aufweist. Die minimale Dicke der fertigen Halbleiterelemente ist nicht mehr durch eine erzielbare minimale Dicke seines Ausgangsmaterials begrenzt. Vorteilhaft ist ferner, dass die Dotierung der übrig gebliebenen Stoppschicht relativ niedrig ist, so dass über die Dotierung des Anodenemitters der Emitterwirkungsgrad eingestellt werden kann.

Auch in der Europäischen Patentanmeldung EP-A-1'017'093 wird ein derartiges Verfahren zur Herstellung eines Halbleiterelementes beschrieben. Dank diesem Verfahren ist es möglich, relativ dünne Halbleiterelemente mit einer typischen Dicke von 80-180 $\mu$m herzustellen. In diesem Verfahren wird vorzugsweise ein Dotierprofil gewählt, welches einem Gaussprofil oder einem komplementären Fehlerfunktionsprofil entspricht. Nach der Dünnung bleibt somit von der Sperrzone nur noch eine Restzone oder Tail, im folgenden Schwanzsperrzone genannt, übrig. Die Dotierung und anschliessend die Dünnung werden so vorgenommen, dass die Schwanzsperrzone an seiner anodenseitigen Oberfläche eine Dotierdichte von mindestens $5\times10^{14}$ cm$^{-3}$, vorzugsweise $1\times10^{15}$ cm$^{-3}$ und maximal $6\times10^{16}$ cm$^{-3}$, vorzugsweise $1\times10^{16}$ cm$^{-3}$ aufweist. Diese Werte entsprechen Erfahrungswerten der Anmelderin und sollen eine negative Beeinflussung der Anodeneffizienz vermeiden.

Mit diesen Erfahrungswerten werden zwar gute Resultate erzielt. Die Herstellung derartig gedünnter Halbleiterelemente basiert jedoch nach wie vor auf den Erfahrungswerten, welche bei der Herstellung von PT-Halbleiterelementen nach der Epitaxiemethode und bei der Herstellung von ungedünnten NPT-Halbleiterelementen gewonnen wurden. Es werden deshalb nicht alle Möglichkeiten zur Optimierung von gedünnten Halbleiterelementen ausgenützt.

**Darstellung der Erfindung**

Es ist deshalb Aufgabe der vorliegenden Erfindung, das obengenannte Verfahren zur Herstellung eines verdünnten Leistungshalbleiterelementes zu verbessern, so dass sich ein optimiertes Halbleiterelement schaffen lässt. Insbesondere soll seine Dicke auf eine jeweils gewünschte Spannungsfestigkeit optimierbar sein.

Diese Aufgabe löst ein Verfahren mit den Merkmalen des Patentanspruches 1 sowie ein Halbleiterelement mit den Merkmalen des Patentanspruches 5.

Erfindungsgemäss wird eine quantitative Optimierung des Herstellungsverfahrens und somit eines gedünnten Halbleiterelementes ermöglicht. In dieser quantitativen Optimierung werden diverse Parameter und ihre Relation zueinander berücksichtigt, insbesondere eine Dotierstoff-Flächendichte einer Schwanzsperrzone, eine Dotierstoffdichte an einer anodenseitigen Oberfläche der Schwanzsperrzone, eine Dotierstoffdichte einer Basis, eine charakteristische Abfall-Länge beziehungsweise Steigung des Dotierprofils der Schwanzsperrzone sowie eine Dicke einer aus dem Wafer resultierenden Basis von Anode zu Kathode.

In einer ersten Variante des Verfahrens wird für eine jeweils geforderte Spannungsfestigkeit ein unterer und ein oberer Grenzwert für die Dotierstoff-Flächendichte der Schwanzsperrzone angegeben. Dabei variieren die Grenzen in direkter und/oder indirekter Abhängigkeit der oben angegebenen Parameter. Die obere Grenze berücksichtigt eine charakteristische Abfall-Länge des Dotierprofils der Schwanzsperrzone und die untere Grenze einen Punch-Through-Grad, welcher als Verhältnis einer Punch-Through-Spannung gemäss Formel (8) und einer Lawinendurchbruchspannung definiert ist.

In einer zweiten Variante des Verfahrens wird das Halbleiterelement optimiert indem das Produkt der Dotieratomdichte der Schwanzsperrzone an der Oberfläche mit der charakteristischen Abfall-Länge der Schwanzsperrzone in eine feste Relation zur Lawinen-Durchbruchspannung gebracht wird.

Weitere vorteilhafte Varianten und Ausführungsformen gehen aus den abhängigen Patentansprüchen hervor.

**Kurze Beschreibung der Zeichnungen**

Im folgenden wird das erfindungsgemässe Verfahren und der Erfindungsgegenstand anhand eines bevorzugten Ausführungsbeispiels, welches in den beiliegenden Zeichnungen dargestellt ist, näher erläutert. Es zeigen:

Figur 1a-1e     die Herstellung eines Halbleiterelementes vom Ausgangsmaterial bis zum Endprodukt gemäss EP-A-1'017'093;

Figur 2     eine graphische Darstellung eines Diffusionsprofils sowie des elektrischen Feldes im Sperrbetrieb entlag dem Schnitt A-A' gemäss Figur 1b bzw. dem Schnitt A-B gemäss Figur le und

Figur 3     eine graphische Darstellung einer Dotierdichte in Funktion eines Abstandes x von der Anode;

Figur 4     eine graphische Darstellung einer unteren Grenze für eine Dotieratom-Flächendichte $N_{tail,\ min}$ in Funktion von $\gamma$ für verschiedene Lawinendurchbruch-Spannungswerte V;

Figur 5     eine graphische Darstellung einer optimalen Basisdotierung $N_{opt}$ und eines optimalen spezifischen Basiswiderstandes in Funktion einer maximalen Lawinendurchbruch-Spannung V;

Figur 6     eine graphische Darstellung der Differenz einer optimierten Dicke W eines Halbleiterelementes und einer charakteristischen Länge L einer Schwanzsperrzone in Funktion der maximalen Durchbruchspannung V und

Figur 7     eine graphische Darstellung eines optimalen Produkts einer Oberflächenkonzentration $N_s$ mit einer charakteristischen Abfall-Länge L in Funktion der maximalen Durchbruchspannung V.

**Wege zur Ausführung der Erfindung**

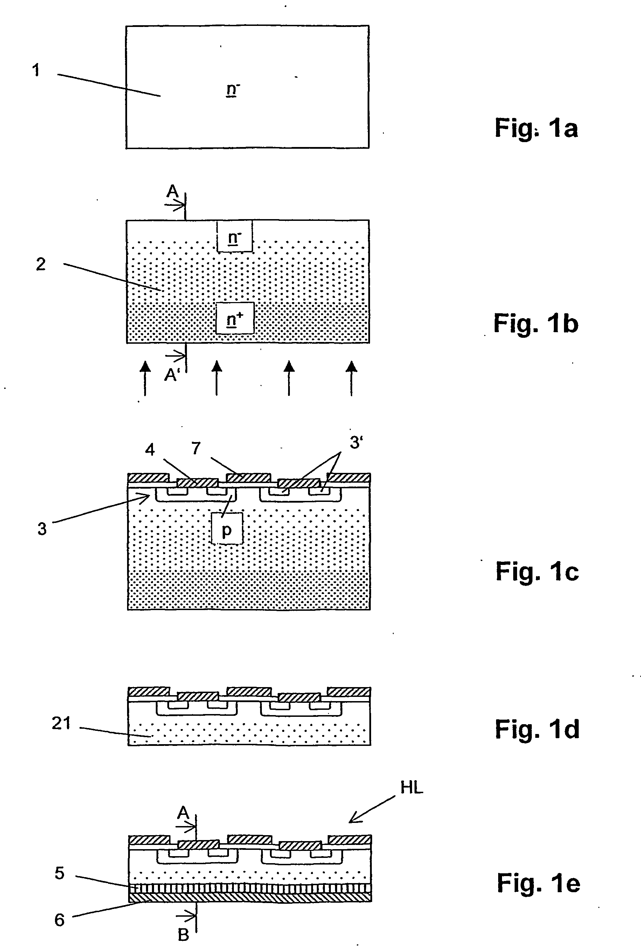

Die Figuren 1a-1e zeigen ein Herstellungsverfahren für verdünnte Leistungshalbleiterelemente, wie es in EP-A-1'017'093 ausführlich beschrieben ist. Dieses Verfahren eignet sich insbesondere zur Herstellung von IGBT's, es ist jedoch auch auf andere Leistungshalbleiterelemente anwendbar.

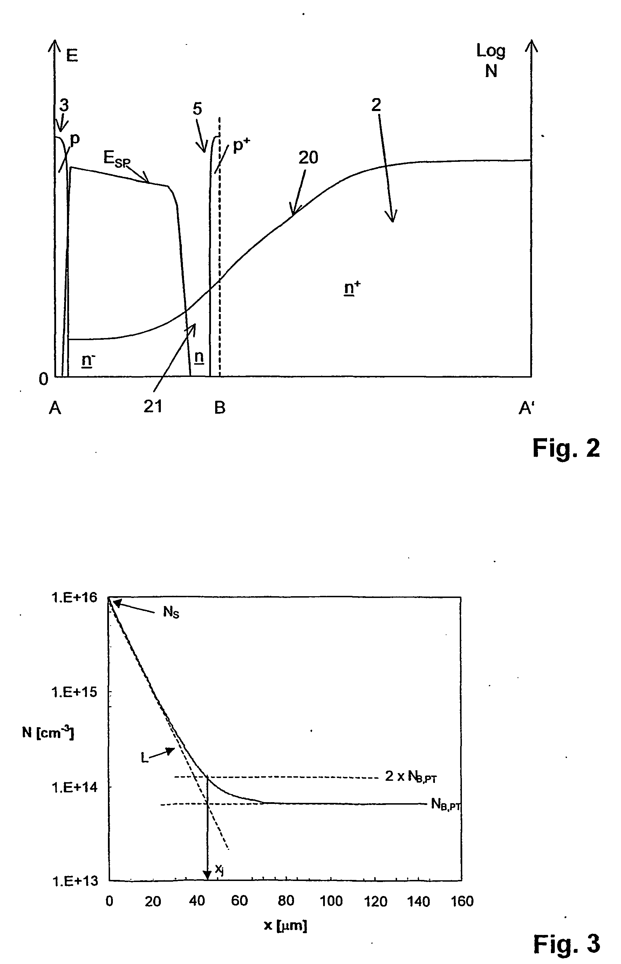

Im folgenden wird auf das Verfahren nicht eingehend eingegangen, sondern es seien nur die wesentlichsten Schritte nochmals angeführt. Es wird von einem einstückigen, vorzugsweise uniform n-dotierten Wafer 1 mit einer typischen Dicke von 400 - 600 $\mu$m, wie er in Figur 1a dargestellt ist, ausgegangen. Im Wafer 1 wird, wie in Figur 1b sichtbar, ein Diffusionsprofil 2 erzeugt, welches quellenseitig zunimmt (Figur 2), wobei es von einer niedrig n-dotierten Zone in eine hochdotierte $n^+$ -Zone übergeht. Die Form des Dotierprofils ist dabei vorzugsweise gaussförmig oder entspricht einer komplementären Fehlerfunktion. In einem nächsten Schritt, welcher in Figur 1c dargestellt ist, wird eine Kathodenstruktur 3 mit einer $n^+$-dotierten Kathode 3', eine Kathodenmetallisierung 4 und vorzugsweise eine Steuerelektrode 7 mittels bekannter Prozesse auf- beziehungsweise eingebracht.

In einem nächsten Schritt gemäss Figur 1d wird nun der Wafer 1 anodenseitig in seiner Dicke reduziert, vorzugsweise durch Schleifen und Ätzen, so dass lediglich noch eine Schwanzsperrzone 21 übrigbleibt. Erwünscht wird dabei eine Schwanzsperrzone mit einer möglichst flachen Flanke und einer niedrigen Dotierung, so dass das vorgängige Diffusionsprofil möglichst tief sein sollte.

Anschliessend wird auf die Oberfläche dieser Schwanzsperrzone 21 eine Anode mit einem $p^+$-dotierten, transparenten Anodenemitter eingebracht, indem eine Randzone entsprechend dotiert wird. Anschliessend wird auch auf dieser Seite eine zweite Metallschicht, die Anodenmetallisierung 6, zur Kontaktierung aufgebracht.

Erfindungsgemäss wird nun dieses Herstellverfahren mittels einer Dimensionierungsregel quantitativ optimiert. Die Optimierung erfolgt dabei hinsichtlich einer vorgegebenen Lawinen-Durchbruchspannung, auch Durchbruchspannung genannt. In dieser Dimensionierungsregel werden diverse Prozessparameter und ihre Relation zueinander berücksichtigt, insbesondere die Dotieratom-Flächendichte der Schwanzsperrzone, die Dotieratomdichte an der anodenseitigen Oberfläche, die Dotieratomdichte des Wafers beziehungsweise der aus ihm entstandenen Basis, eine charakteristische Abfall-Länge der Schwanzsperrzone sowie die Dicke des Halbleiterelementes, genauer der Basis von Anode zu Kathode.

Im Folgenden wird die Dimensionierungsregel gemäss einer ersten Variante des erfindungsgemässen Verfahrens beschrieben:

Es wird von einer Schwanzsperrzone ausgegangen, welche aus einem tiefen Diffusionsprofil in Gaussform oder einer komplementären Fehlerfunktionsform entstanden ist. In Abhängigkeit der gewünschten Spannungsfestigkeit wird ein unterer und ein oberer Grenzwert für die Dotieratomflächendichte der Schwanzsperrzone angegeben. Dabei berücksichtigt die obere Grenze eine charakteristische Abfall-Länge des Dotierprofils der Schwanzsperrzone und die untere Grenze einen Punch-Through-Grad, welcher im Folgenden erläutert wird.

Die obere Grenze wird in dem Bereich festgelegt, ab welchem sie die Anodeneffizienz merklich beeinflussen würde. Solange diese obere Grenze nicht erreicht wird, bleiben zudem die Prozessparameter kontrollierbar, so dass bei der Herstellung die Anzahl mangelhafter Halbleiterelemente gering gehalten werden kann.

Die Schwanzsperrzone weist eine Grunddotierung $N_0$ und mindestens annähernd ein zusätzliches Dotierprofil auf gemäss der Funktion

$$N(x) = N_s \cdot \exp\left(-\frac{x}{L}\right) \qquad\qquad (1)$$

wobei $N_s$ die Dotierstoff-Dichte [$cm^{-3}$] in der anodenseitigen Oberfläche der Schwanzsperrzone ist und $N_0$ die Dotierstoffdichte des Wafers beziehungsweise der daraus entstehenden Basis ist. $x$ ist die Position [cm] in einem Koordinatensystem mit Ursprung am pn-Übergang von der Schwanzsperrzone zur Anode, wobei $x$ in Richtung Kathode aufsteigt, wie dies in Figur 3 dargestellt ist. $L$ ist die Abfall-Länge des Dotierprofils in der Schwanzsperrzone, wobei $L$ durch die Steigung der Geraden durch $N(x=0)$ und $N(x_j)$ gegeben ist, mit $x_j$ als den Punkt, an welchem die totale Dotierung den zweifachen Wert der Basisdotierung $N_0$ aufweist

Die in der Schwanzsperrzone enthaltene Dotieratom-Flächendichte ist gegeben durch

$$N_{tail} = \int_0^{x_j+W_{PT}} N(x)\cdot dx = \int_0^{x_j+W_{PT}} N_S \cdot \exp(-\frac{x}{L})\cdot dx \qquad (2)$$

$W_{PT}$ ist weiter unten im Text definiert. Da im praktischen Fall $N_s$ an der Kathode zu Null abgefallen ist, kann man die Integration ohne wesentlichen Fehler auf $\infty$ setzen.

$$N_{tail} = \int_0^{\infty} N_S \cdot \exp(-\frac{x}{L})\cdot dx = N_S \cdot L \qquad (3)$$

welche somit die Dotieratom-Flächendichte in der Schwanzsperrzone in Abhängigkeit der Oberflächenkonzentration $N_s$ angibt. Ausgehend von einer maximal tolerierbaren Oberflächenkonzentration von $N_{s,max}$ = $10^{16}$ cm$^{-3}$ erhält man so die maximale Dotieratom-Flächendichte $N_{tail,max}$ in der Schwanzsperrzone und somit als obere Grenze für einen gegebenen Wert von L

$$N_{tail,max} = 10^{16}\,cm^{-3}\cdot L \qquad . \qquad (4)$$

Im Falle, dass der Donatortyp der Schwanzsperrzone n-wertig ist, wobei n der Anzahl der bei Raumtemperatur vom Donator ins Leitungsband emittierten Elektronen entspricht, wird der Wert gemäss Formel (4) durch n dividiert,
**[0027]** Die untere Grenze der Dotieratom-Flächendichte wird im Bereich festgelegt, in welchem im Blockierbetrieb das elektrische Feld bis zum Erreichen des Lawinendurchbruchs in der Schwanzsperrzone komplett abgebaut sein muss. Im Speziellen darf das elektrische Feld keinesfalls die Anodendiffusion erreichen, bevor der Lawinendurchbruch eintritt. Andernfalls kommt es zum Punch-Through Durchbruch, der im Gegensatz zum Lawinendurchbruch mit grosser Wahrscheinlichkeit zur Zerstörung des Halbleiters führt. Dabei soll das maximale elektrische Feld $E_{max}$ beim Eintritt des Lawinendurchbruchs folgender Formel genügen

$$E_{max} \cong K \cdot N_0^{1/8} \qquad (5)$$

mit K = 4010 V cm$^{-5/8}$
Die Berechnung der minimalen Dotieratom-Flächendichte in der Stoppschicht wird auf Raumtemperatur beschränkt, da dies den schlechtesten Fall darstellt. Bei höherer Temperatur wird aufgrund der vergrösserten Feldstärke im Lawinendurchbruch auch eine höhere Dotieratom-Flächendichte benötigt. Diese liegt jedoch noch weit unterhalb der bereits genannten oberen Grenze. Dasselbe gilt auch für die ebenfalls getroffene Idealisierung, dass die Spannungsausbeute des Lawinendurchbruchs 100% beträgt.
Es besteht folgender Zusammenhang zwischen einer Spannung $V_{br,PT}$, bei Lawinendurchbruch und der n-Basis mit der Dicke $W_{PT}$, wobei $W_{PT}$ definiert ist als die Länge von $x_j$ bis zur kathodenseitigen Oberfläche der Basis bzw. bis zu einem pn-Übergang der Basis

$$V_{br,PT} \cong (K \cdot N_{B,PT}^{1/8} - \frac{q \cdot N_{B,PT}}{2 \cdot \varepsilon_{Si} \cdot \varepsilon_0} \cdot W_{PT}) \cdot W_{PT} \qquad , \qquad (6)$$

wobei $\varepsilon_{Si}$ die Dielektrizitätskonstante des Wafermaterials, hier von Silizium, ist und in diesem Fall ca. 11.9 beträgt, und $\varepsilon_0$ die Permittivität des Vakuums bezeichnet. $q$ ist die Ladung des Elektrons.
Zur Bestimmung der unteren Grenze wird nun ein Punch-Through Grad $\gamma$ eingeführt

$$\gamma \equiv \frac{V_{punch-through}}{V_{br,PT}} \quad , \tag{7}$$

wobei $V_{punch-through}$ für die Spannung steht, bei der das elektrische Feld auf die Schwanzsperrzone aufläuft. $V_{punch-through}$ sei dabei definitionsgemäss die an den äusseren Kontakten angelegte Spannung, bei der das elektrische Feld in Abwesenheit der Stoppschicht am Ort $x = x_j$ zu Null wird:

$$V_{punch-through} = \frac{q \cdot N_{B,PT}}{2 \cdot \varepsilon_{Si} \cdot \varepsilon_0} \cdot W_{PT}^2 \quad . \tag{8}$$

Dadurch ergibt sich

$$W_{PT} = \sqrt{\frac{2 \cdot \varepsilon_{Si} \cdot \varepsilon_0}{q \cdot N_{B,PT}} \cdot \gamma \cdot V_{br,PT}} \quad . \tag{9}$$

Aus $N_{B,PT}$ und $W_{PT}$ lässt sich nun unter Anwendung der Poisson-Gleichung der Verlauf des elektrischen Feldes beim Lawinendurchbruch ($V_{br,PT}$) bestimmen. An der Grenze zur Stoppschicht beträgt unter diesen Bedingungen das elektrische Feld

$$E(W_{PT}) \cong K \cdot N_{B,PT}^{1/8} - \frac{q \cdot N_{B,PT}}{\varepsilon_{Si} \cdot \varepsilon_0} \cdot W_{PT} \quad . \tag{10}$$

Um das Feld von $E(W_{PT})$ auf Null zu senken, ist unabhängig von der Form des Dotierprofils in der Stoppschicht als untere Grenze für die Dotieratom-Flächendichte

$$N_{tail,min} \equiv \frac{E(W_{PT}) \cdot \varepsilon_{Si} \cdot \varepsilon_0}{q} \tag{11}$$

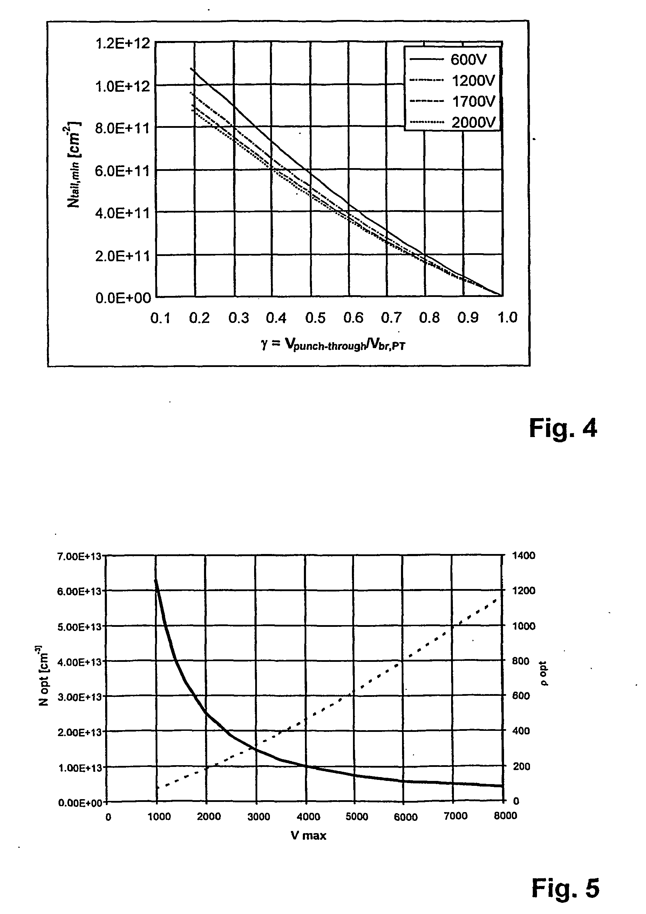

notwendig. Die Werte lassen sich auf numerischem Weg erhalten. Figur 4 zeigt die untere Grenze der Dotieratom-Flächendichte $N_{tail,\ min}$ in Funktion von $\gamma$ für verschiedene Durchbruchspannungswerte V. Im Falle, dass der Donatortyp in der Schwanzsperrzone $n$-wertig ist, sind die Werte der Dotieratom-Flächendichte gemäss Figur 4 durch $n$ zu dividieren.

Im folgenden wird die Dimensionierungsregel gemäss einer zweiten Variante des erfindungsgemässen Verfahrens beschrieben:

Es wird wiederum von einer Schwanzsperrzone ausgegangen, deren Dotierkonzentration näherungsweise die folgende Form aufweist:

$$N(x) = N_0 + N_s \cdot \exp(-x/L) \quad . \tag{12}$$

Dabei ist $N_0$ wiederum die Dotierung der Basis, $N_S$ die Oberflächenkonzentration an der anodenseitigen Oberfläche der Schwanzsperrzone und $L$ die charakteristische Abfall-Länge des Dotierprofils in der Schwanzsperrzone.
Die Prozessparameter Breite $W$ der Basis, charakteristische Länge $L$ des Dotierprofils, Dotierdichte $N_0$ der Basis und Oberflächendotierdichte $N_s$ der Schwanzsperrzone sollen nun in eine optimierte Relation zueinander gebracht werden, um erfindungsgemäss ein optimiertes verdünntes Leistungshalbleiterelement herzustellen. Für die Optimierung sollen dabei folgende Kriterien erfüllt sein:

- Bei der Durchbruchspannung V soll sich die Raumladungszone mindestens annähernd genau bis zur Anode erstrecken und
- Bei der Durchbruchspannung V soll das maximale elektrische Feld an der Kathode dem Durchbruchfeld entsprechen.
- Für eine gegebene Basisdicke soll die Durchbruchsspannung maximiert werden.

In dieser Variante des Verfahrens ist W als $W_b$ bezeichnet, welches sich vom oben verwendeten $W_{PT}$ unterscheidet. $W_b$ ist die Breite der Basis, gemessen vom anodenseitigen pn-Übergang bis zur kathodenseitigen Oberfläche der Basis bzw. bis zu einem pn-Übergang der Basis.

Aus Gleichung (12) wird für das elektrische Feld erhalten

$$E(W_b) = \frac{q}{\varepsilon \cdot \varepsilon 0} \cdot (N_0 \cdot W_b + N_s \cdot L \cdot (1 - \exp(-W_b / L))) \qquad (13)$$

Da $\exp(-W_b/L) \ll 1$ ist, folgt aus Gleichung (13)

$$E(W_b) = \frac{q}{\varepsilon \cdot \varepsilon 0} \cdot (N_0 \cdot W_b + N_s \cdot L) \qquad (14)$$

Die maximale Durchbruchspannung ist gegeben als

$$V_{\max}(W_b) = \frac{q}{2} \cdot \frac{N_0 \cdot W_b^2 + 2 \cdot L \cdot N_s \cdot W_b - 2 \cdot L^2 \cdot N_s}{\varepsilon \cdot \varepsilon_0} \qquad (15)$$

Dabei entspricht die Druchbruchspannungpannung V der in der ersten Variante beschriebenen Durchbruchspannung $V_{br,PT}$.

Eine Buffer-Ladung sei definiert als

$$Q_b = q \cdot \int_0^{w_b} N_s \cdot \exp(-\frac{x}{L}) dx = q \cdot L \cdot N_s \qquad (16)$$

und eine Ladung der n-Basis als

$$Q_0 = q \cdot N_0 \cdot W_b \qquad (17)$$

Daraus ergibt sich

$$E(W_b) = \frac{Q_0 + Q_b}{\varepsilon \cdot \varepsilon 0} \qquad (18)$$

Berücksichtigt man nun das elektrische Feld beim Durchbruch

$$E_{max} = K \cdot N_0^{1/8} \quad , \qquad\qquad (19)$$

wobei normalerweise gilt $K = 4010 \cdot V \cdot cm^{-5/8}$, ergibt sich für die maximale Spannung

$$V = K \cdot N_0^{1/8} \cdot (W_b - L) - \frac{q \cdot N_0}{\varepsilon \cdot \varepsilon 0} \cdot \left(\frac{W_b^2}{2} - W_b \cdot L\right) \quad . \qquad (20)$$

Die optimale Dotierungsdichte in der Basis lässt sich berechnen aus $N_0$ für den Fall, dass das elektrische Feld an der Junction dem maximalen elektrischen Feld entspricht:

$$N_{opt} = \left[\frac{\varepsilon \cdot \varepsilon 0 \cdot K \cdot (W_b - L)}{4 \cdot q \cdot W_b \cdot (W_b - 2 \cdot L)}\right]^{\frac{8}{7}} \qquad\qquad (21)$$

Für den Fall, dass $(W_b/L)^2 \gg 1$, lässt sich eine neue Variable $W_{red} = W_b - L$ definieren, so dass aus den Gleichungen (20) und (21) folgt:

$$V \approx K \cdot N_0^{1/8} \cdot W_{red} - \frac{q \cdot N_0}{2 \cdot \varepsilon \cdot \varepsilon 0} \cdot W_{red}^2 \qquad\qquad (22)$$

$$N_{opt} \approx \left[\frac{\varepsilon \cdot \varepsilon 0 \cdot K \cdot}{4 \cdot q \cdot W_{red}}\right]^{\frac{8}{7}} \qquad\qquad (23)$$

Daraus lässt sich eine optimale Durchbruchspannung berechnen

$$V_{opt} = \frac{7}{8} \cdot W_{red} \cdot N_{opt}^{1/8} \cdot K = \frac{7}{8} \cdot W_{red} \cdot E_{max} \qquad\qquad (24)$$

und ein minimale Dicke der Basis beziehungsweise des Halbleiterelementes, welches für diese Durchbruchspannung noch geeignet ist:

$$W_{red}^{min} = \frac{8}{7 \cdot N_{opt}^{1/8} \cdot K} \cdot V \quad , \qquad\qquad (25)$$

welches numerisch wird zu

$$W_{red}^{min} = 1.70 \cdot 10^{-2} \cdot V^{\frac{7}{6}} \qquad\qquad (26)$$

mit W in $\mu$m und V in Volt.

Daraus ergibt sich für die optimale Dotierdichte in der n-Basis

$$N_{opt} = \frac{7 \cdot 14^{\frac{1}{3}}}{128} \cdot (\varepsilon \cdot \varepsilon_0 \cdot \frac{K^2}{q})^{\frac{4}{3}} \cdot V^{-\frac{4}{3}} \qquad (27)$$

und numerisch

$$N_{opt}(\text{in cm}^{-3}) = 6.31\ 10^{17}\ V^{-4/3}\ [\text{ inVolt}^{-4/3}] \qquad (28)$$

Dabei ergibt sich, dass Werte für $N_{opt}$ von bis zu $8 \cdot 10^{17}\ V^{-4/3}$ zu brauchbaren Resultaten führen.
Für die optimale Oberflächenkonzentration der Schwanzsperrzone ergibt sich über Berechnung der optimalen Buffer-Ladung

$$N_s = (\frac{1}{W_{red}^{min}})^{\frac{1}{7}} \cdot \left[ \frac{K \cdot \varepsilon \cdot \varepsilon_0}{4 \cdot q} \right]^{\frac{8}{7}} \cdot \frac{3}{L} \qquad (29)$$

oder numerisch (V in V-, $N_s$ in cm$^{-3}$, L und $W_{red}$ in $\mu$m)

$$N_s \cdot L = 1.79 \cdot 10^{16} \cdot W_{red}^{-\frac{1}{7}} \qquad (30)$$

$$N_s \cdot L = 3.20 \cdot 10^{16} \cdot V^{-\frac{1}{6}} \qquad (31)$$

Somit wird in dieser zweiten Variante des Verfahrens eine feste Beziehung zwischen dem Produkt der Dotieratomdichte der Schwanzsperrzone an der Oberfläche und der Abfall-Länge der Schwanzsperrzone in Abhängigkeit der Durchbruchspannung erhalten. Werden für $N_s$ und L Werte gewählt, welche mindestens annähernd diesem Produkt entsprechen, so wird ein optimales Halbleiterelement geschaffen. Unter mindestens annähernd wird insbesondere ein Faktor F verstanden, welcher zwischen 0.5 und 1.2 liegt.
Vorzugsweise wird für L eine Länge von 5-10 $\mu$m gewählt, wodurch eine Oberflächenkonzentration $N_s$ in der Grössenordnung von $10^{15}$ cm$^{-3}$ erzielbar ist.

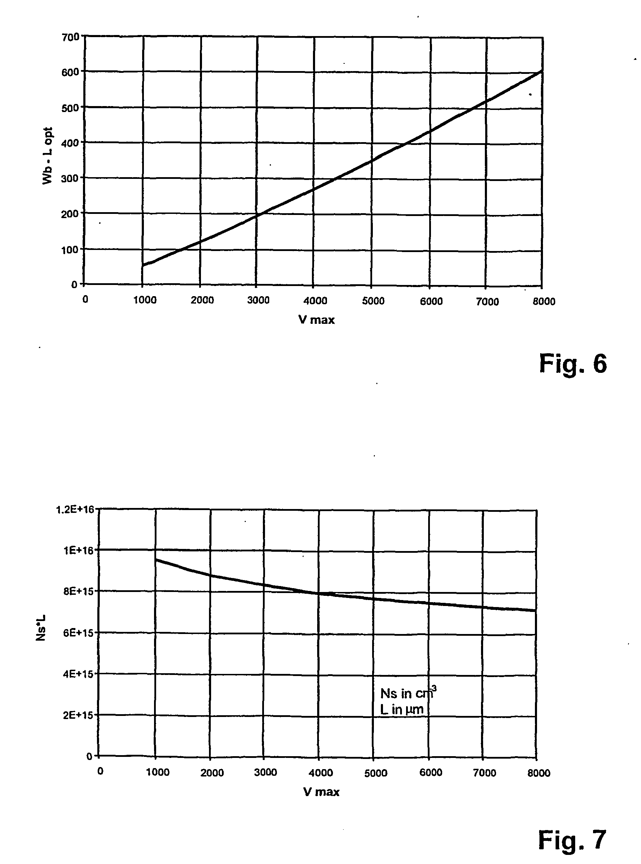

In den Figuren 5 bis 7 sind numerische Werte der einzelnen Prozessparameter beziehungsweise von Kombinationen davon dargestellt. Diese numerischen Werte wurden durch die in der zweiten Variante des Verfahrens verwendeten Formeln erhalten. Figur 5 zeigt einerseits eine optimale Basisdotierung $N_{opt}$ und andererseits den optimalen spezifischen Basiswiderstand in Funktion der maximalen Durchbruchspannung $V_{max}$. Figur 6 zeigt die Differenz der optimierten Dicke W des Halbleiterelementes und der charakteristischen Länge L der Schwanzsperrzone in Funktion der maximalen Durchbruchspannung $V_{max}$ und Figur 7 stellt das optimale Produkt der Oberflächenkonzentration $N_s$ mit der charakteristischen Abfall-Länge L in Funktion der maximalen Durchbruchspannung $V_{max}$ dar.
Anhand der obengenannten Dimensionierungsregeln lassen sich Halbleiterelemente schaffen, welche für ihren speziellen Anwendungszweck optimiert sind, wobei ihre Entwicklungszeit wie auch die Kosten für ihre Herstellung minimiert werden können.

**Bezugszeichenliste**

1    Wafer

| | |
|---|---|
| 2 | Diffusionsgebiet |
| 20 | Dotierprofil |
| 21 | Stoppzone |
| 3 | Kathodenstruktur |
| 3' | Kathode |
| 4 | Kathodenmetallisierung |
| 5 | Anode |
| 6 | Anodenmetallisierung |
| 7 | Steuerelektrode |
| HL | Halbleiterelement |
| $E_{SP}$ | Elektrisches Feld im Sperrbetrieb |

**Patentansprüche**

1. Verfahren zur Herstellung eines Halbleiterbauelementes mit einer Kathode und einer Anode, welches Verfahren folgende Schritte umfasst:

- aus einem Wafer mit einer Grunddotierdichte $N_0$, welcher Wafer eine Kathodenseite und eine der Kathodenseite gegenüberliegende Anodenseite umfasst, wird zuerst eine Kathode mit einer Kathodenmetallisierung auf der Kathodenseite erzeugt,
- daraufhin die Dicke des Wafers auf der Anodenseite reduziert,
- und in einem weiteren Schritt auf der Anodenseite eine Anode erzeugt,

wobei vor der Erzeugung der Kathode eine Stoppschicht auf der Anodenseite eingebracht wird und durch die Reduzierung der Waferdicke die Stoppschicht bis auf eine Schwanzsperrschichtzone entfernt wird, **dadurch gekennzeichnet, dass** die verbleibende Schwanzsperrschichtzone wie folgt ausgebildet ist:

- die verbleibende Schwanzsperrschichtzone weist eine Dotieratom-Flächendichte auf, welche zwischen einer minimalen und einer maximalen Dotieratom-Flächendichte liegt, wobei die maximale Dotierstoff-Flächendichte als Produkt aus einer maximal tolerierbaren Oberflächendotierdichte an der Oberfläche der Schwanzsperrzone auf der Anodenseite und einer charakteristischen Abfall-Länge des Dotierprofils in der Schwanzsperrzone gegeben ist, und die charakteristische Abfall-Länge des Dotierprofils gegeben ist durch

$$L = \frac{x_j}{\ln(\frac{N_s}{N_0})}$$

mit L: charakteristische Abfall-Länge des Dotierprofils;
$x_j$ : Entfernung zwischen einem pn Übergang, welcher zwischen der Schwanzsperrzone und der Anode liegt, und einem Punkt, an welchem die Dotierdichte auf das Doppelte des Wertes der Grunddotierdichte $N_0$ abgefallen ist;
$N_s$ : Oberflächendotierdichte;
$N_0$ : Grunddotierung;
und wobei die minimale Dotieratom-Flächendichte gegeben ist als

$$N_{tail,min} \equiv \frac{E(W_{PT}) * \varepsilon_{Si} * \varepsilon_0}{q}$$

mit $N_{tail, min}$ : minimale Dotieratom-Flächendichte;
$E(W_{PT})$ elektrisches Feld an dem pn Übergang beim Lawinenzusammenbruch;
$\varepsilon_{Si}$ : Dielektrizitätskonstante des Wafers;
$\varepsilon_0$ : Permittivität des Vakuums; und
q: Elektronenladung;

oder **dadurch gekennzeichnet, dass**
- die verbleibende Schwanzsperrschichtzone **dadurch gekennzeichnet**, eine Oberflächendotierdichte an der Oberfläche der Schwanzsperrzone auf der Anodenseite aufweist und es gilt mindestens

$$L = (\frac{1}{W_{red}^{\min}})^{\frac{1}{7}} \cdot \left[\frac{K \cdot \varepsilon \cdot \varepsilon_0}{4 \cdot q}\right]^{\frac{8}{7}} \cdot \frac{3}{N_S}$$

mit L: charakteristische Abfall-Länge des Dotierprofils;

$W_{red}^{min}$ : minimale Dickendifferenz zwischen der Waferdicke und der charakteristischen Abfall-Länge des Dotierprofils;

K = 4010 V * cm$^{-5/8}$;

$\varepsilon_{Si}$ : Dielektrizitätskonstante des Wafers;

$\varepsilon_0$ : Permittivität des Vakuums;

q: Elektronenladung; und

$N_s$ : Oberflächendotierdichte.

2. Verfahren nach Anspruch 1, **dadurch gekennzeichnet, dass** die maximal tolerierbare Oberflächendotierdichte $10^{16}$ cm$^{-3}$ ist.

3. Verfahren nach Anspruch 1, **dadurch gekennzeichnet, dass** der Wafer mit einer Dotierdichte versehen wird von

$$N_{opt} = \frac{7 \cdot 14^{\frac{1}{3}}}{128} \cdot (\varepsilon \cdot \varepsilon_0 \cdot \frac{K^2}{q})^{\frac{4}{3}} \cdot V^{-\frac{4}{3}} F$$

mit $N_{opt}$ : Grunddotierung; und

V: Lawinendurchbruchsspannung, wobei $N_{opt}$ um einen Faktor F = 0.5 bis 1.2 von dem errechneten Wert variieren kann.

4. Verfahren nach Anspruch 2, **dadurch gekennzeichnet, dass** die minimale Differenz der Waferdicke und der charakteristischen Abfall-Länge des Dotierprofils gleich $W_{red}^{\min} = \frac{8}{7 \cdot N_{opt}^{1/8} \cdot K} \cdot V * F$ ist, wobei $W_{red}^{min}$ um einen Faktor F = 0.5 bis 1.2 von dem errechneten Wert variieren kann.

5. Halbleiterbauelement, umfassend

- eine Schicht mit einer Grunddotierdichte, welche Schicht eine Kathodenseite und eine der Kathodenseite gegenüberliegende Anodenseite aufweist,
- eine Stoppschicht,
- eine Anode auf der Anodenseite, wobei die Stoppschicht zwischen der Schicht mit der Grunddotierdichte und der Anode angeordnet ist, und
- eine Kathode mit einer Kathodenmetallisierung auf der Kathodenseite,

**dadurch gekennzeichnet, dass** die Stoppschicht eine Dotieratom-Flächendichte aufweist, welche zwischen einer maximalen und einer minimalen Dotieratom-Flächendichte liegt, wobei die maximale Dotieratom-Flächendichte als Produkt aus einer maximal tolerierbaren Oberflächendotierdichte an der Oberfläche der Schwanzsperrzone auf der Anodenseite und einer charakteristischen Abfall-Länge des Dotierprofils in der Schwanzsperrzone gegeben ist, und die charakteristische Abfall-Länge des Dotierprofils gegeben ist durch

$$L = \frac{x_j}{\ln(\frac{N_s}{N_0})}$$

mit L: charakteristische Abfall-Länge des Dotierprofils;

$x_j$ : Entfernung zwischen einem pn Übergang, welcher zwischen der Schwanzsperrzone und der Anode liegt, und einem Punkt, an welchem die Dotierdichte auf die das Doppelte des Wertes der Grunddotierdichte abgefallen ist;

$N_s$ : Oberflächendotierdichte; und

$N_0$ : Grunddotierdichte;

und wobei die minimale Dotieratom-Flächendichte gegeben ist als

$$N_{tail,\min} \equiv \frac{E(W_{PT}) \cdot \varepsilon_{Si} \cdot \varepsilon_0}{q}$$

mit $N_{tail,\ min}$ : minimale Dotieratom-Flächendichte;

$E(W_{PT})$ : elektrisches Feld an dem pn Übergang beim Lawinenzusammenbruch;

$\varepsilon_{Si}$ : Dielektrizitätskonstante des Wafers;

$\varepsilon_0$ : Permittivität des Vakuums; und

q: Elektronenladung.

## Claims

1. Method for producing a semiconductor component having a cathode and an anode, which method comprises the following steps:

   - from a wafer having a basic doping density No, which wafer comprises a cathode side and an anode side lying opposite the cathode side, firstly a cathode having a cathode metallization is produced on the cathode side,
   - the thickness of the wafer is thereupon reduced on the anode side,
   - and, in a further step, an anode is produced on the anode side,

   wherein, before the cathode is produced, a stop layer is introduced on the anode side and the stop layer is removed down to a tail depletion layer zone by reducing the wafer thickness,
   **characterized in that** the remaining tail depletion layer zone is formed as follows:

   - the remaining tail depletion layer zone has a doping atom area density which lies between a minimum and a maximum doping atom area density, therein the maximum dopant area density is given as the product of a maximum acceptable surface doping density at the surface of the tail depletion zone on the anode side and a characteristic decay length of the doping profile in the tail depletion zone, and the characteristic decay length of the doping profile is given by

$$L = \frac{x_j}{\ln\left(\frac{N_s}{N_0}\right)}$$

   where L: characteristic decay length of the doping profile;

   $x_j$ : Distance between a pn junction lying between the tail depletion zone and the anode and a point at which the doping density has fallen to double the value of the basic doping density $N_0$;

   $N_s$: surface doping density;

   $N_0$: basic doping;

and therein the minimum doping atom area density is given as

$$N_{tail,\min} \equiv \frac{E(W_{PT}) * \varepsilon_{si} * \varepsilon_0}{q}$$

where $N_{tail,min}$ : minimum doping atom area density;
$E(W_{PT})$ : electric field at the pn junction upon avalanche breakdown;
$\varepsilon_{Si}$ : dielectric constant of the wafer;
$\varepsilon_0$ : permittivity of free space; and
$q$: electron charge;
or **characterized in that**
the remaining tail depletion layer zone has a surface doping density at the surface of the tail depletion zone on the anode side and at least the following holds true:

$$L = \left(\frac{1}{W_{red}^{\min}}\right)^{\frac{1}{7}} \cdot \left[\frac{K \cdot \varepsilon \cdot \varepsilon_0}{4 \cdot q}\right]^{\frac{8}{7}} \cdot \frac{3}{N_s}$$

where L: characteristic decay length of the doping profile; $W_{red}^{min}$ : minimum thickness difference between the wafer thickness and the characteristic decay length of the doping profile;
K = 4010 V * cm$^{-5/8}$ ;
$\varepsilon_{si}$ : dielectric constant of the wafer;
$\varepsilon_0$ : permittivity of free space;
$q$ : electron charge; and
$N_s$ : surface doping density.

2. Method according to Claim 1, **characterized in that** the maximum acceptable surface doping density is $10^{16}$ cm$^{-3}$.

3. Method according to Claim 1, **characterized in that** the wafer is provided with a doping density of

$$N_{opt} = \frac{7 \cdot 14^{\frac{1}{3}}}{128} \cdot (\varepsilon \cdot \varepsilon_0 \cdot \frac{K^2}{q})^{\frac{4}{3}} \cdot V^{-\frac{4}{3}} F$$

where $N_{opt}$ : Basic doping; and
V: avalanche breakdown voltage, where $N_{opt}$ can vary from the calculated value by a factor F = 0.5 to 1.2.

4. Method according to Claim 2, **characterized in that** the minimum difference between the wafer thickness and the characteristic decay length of the doping profile is equal to $W_{red}^{\min} = \frac{8}{7 \cdot N_{opt}^{1/8} \cdot K} \cdot V * F$ , where $W_{red}^{\min}$ can vary from the calculated value by a factor F = 0.5 to 1.2.

5. Semiconductor component comprising

   - a layer having a basic doping density, which layer has a cathode side and an anode side lying opposite the cathode side,
   - a stop layer,

- an anode on the anode side, wherein the stop layer is arranged between the layer having the basic doping density and the anode, and
- a cathode having a cathode metallization on the cathode side,

**characterized in that** the stop layer has a doping atom area density which lies between a maximum and a minimum doping atom area density, therein the maximum doping atom area density is given as the product of a maximum acceptable surface doping density at the surface of the tail depletion zone on the anode side and a characteristic decay length of the doping profile in the tail depletion zone, and the characteristic decay length of the doping profile is given by

$$L = \frac{x_j}{\ln\left(\frac{N_s}{N_0}\right)}$$

where L: characteristic decay length of the doping profile;
$x_j$ : Distance between a pn junction lying between the tail depletion zone and the anode and a point at which the doping density has fallen to double the value of the basic doping density;
$N_s$ : surface doping density; and
$N_0$: basic doping density;
and therein the minimum doping atom area density is given as

$$N_{tail,\min} \equiv \frac{E(W_{PT}) * \varepsilon_{Si} * \varepsilon_0}{q}$$

where $N_{tail,min}$ : minimum doping atom area density;
$E(W_{PT})$ : electric field at the pn junction upon avalanche breakdown;
$\varepsilon_{Si}$ : dielectric constant of the wafer;
$\varepsilon_0$ : permittivity of free space; and
$q$ : electron charge.


## Revendications

1. Procédé de production d'un composant à semi-conducteur comportant une cathode et une anode, lequel procédé comprend les étapes suivantes :

   - une cathode comportant une métallisation de cathode du côté cathode est tout d'abord réalisée à partir d'une plaquette ayant une densité de dopant de base $N_0$, laquelle plaquette comprend un côté cathode et un côté anode opposé au côté cathode,
   - l'épaisseur de la plaquette est ensuite réduite sur le côté anode,
   - et une anode est réalisée sur le côté anode lors d'une étape supplémentaire,

   dans lequel, avant la réalisation de la cathode, une couche d'arrêt est déposée sur le côté anode et la couche d'arrêt est enlevée du fait de la réduction de l'épaisseur de la plaquette jusqu'à une zone d'une couche d'arrêt de queue, **caractérisé en ce que** la zone de la couche d'arrêt de queue restante est formée de la manière suivants :

   - la zone de la couche d'arrêt de queue restante présente une densité surfacique d'atomes dopants comprise entre des densités surfaciques d'atomes dopants minimale et maximale, la densité surfacique maximale de dopant étant définie comme étant le produit d'une densité surfacique maximale tolérable de dopant à la surface de la zone d'arrêt de queue du côté anode par une longueur caractéristique de décroissance du profil de dopant dans la zone d'arrêt de queue, et la longueur caractéristique de décroissance du profil de dopant étant définie par :

$$L = \frac{x_j}{\ln\left(\dfrac{N_s}{N_0}\right)}$$

où L : longueur caractéristique de décroissance du profil de dopant ;

$x_j$ : distance entre une jonction pn se trouvant entre la zone d'arrêt de queue et l'anode, et un point où la densité de dopant s'est réduite au double de la valeur de la densité de dopant de base $N_0$ ;

$N_s$ : densité surfacique de dopant ;

$N_0$ : dopage de base ;

et où la densité surfacique d'atomes dopants est donnée par :

$$N_{tail,min} \equiv \frac{E(W_{PT}) * \varepsilon_{si} * \varepsilon_0}{q}$$

où $N_{tail,min}$ = densité surfacique minimale d'atomes dopants ;

$E(W_{PT})$ : champ électrique au niveau d'une jonction pn lors d'un claquage par avalanche ;

$\varepsilon_{si}$ : constante diélectrique de la plaquette ;

$\varepsilon_0$ : permittivité du vide ; et

q : charge de l'électron ;

ou **caractérisé en ce que** :

- la zone de la couche d'arrêt de queue restante présente une densité surfacique de dopant à la surface de la zone d'arrêt de queue du côté anode et **en ce qu'**on a au moins :

$$L = \left(\frac{1}{W_{red}^{min}}\right)^{\frac{1}{7}} \cdot \left[\frac{K \cdot \varepsilon \cdot \varepsilon_0}{4 \cdot q}\right]^{\frac{8}{7}} \cdot \frac{3}{N_s}$$

où L : longueur caractéristique de décroissance du profil de dopant ;

$W_{red}^{min}$ **:** différence d'épaisseur minimale entre l'épaisseur de la plaquette et la longueur caractéristique de décroissance du profil de dopant ;

K = 4010 V * cm$^{-5/8}$ ;

$\varepsilon_{si}$ : constante diélectrique de la plaquette ;

$\varepsilon_0$ permittivité du vide ;

q : charge de l'électron ; et

$N_s$ : densité surfacique de dopant.

2. Procédé selon la revendication 1, **caractérisé en ce que** la densité surfacique maximale tolérable de dopant est de $10^{16}$ cm$^{-3}$.

3. Procédé selon la revendication 1, **caractérisé en ce que** la plaquette présente une densité de dopant de

$$N_{opt} = \frac{7 \cdot 14^{\frac{1}{3}}}{128} \cdot (\varepsilon \cdot \varepsilon_0 \cdot \frac{K^2}{q})^{\frac{4}{3}} \cdot V^{-\frac{4}{3}} F$$

où $N_{opt}$ : dopage de base ; et

V : tension de claquage par avalanche, $N_{opt}$ pouvant varier d'un facteur F = 0,5 à 1,2 de la valeur calculée.

4. Procédé selon la revendication 2, **caractérisé en ce que** la différence minimale entre l'épaisseur de la plaquette et la longueur caractéristique de décroissance du profil de dopant est égale à $W_{red}^{\min} = \dfrac{8}{7 \cdot N_{opt}^{1/8} \cdot K} \cdot V * F$ , où

$W_{red}^{\min}$ peut varier d'un facteur F = 0,5 à 1,2 de la valeur calculée.

5.  Composant à semi-conducteur, comprenant :

> - une couche ayant une densité de dopant de base, laquelle couche présente un côté cathode et un côté anode opposé au côté cathode,
> - une couche d'arrêt,
> - une anode sur le côté anode, la couche d'arrêt étant disposée entre la couche ayant la densité de dopage de base et l'anode, et
> - une cathode comportant une métallisation de cathode du côté cathode,

> **caractérisé en ce que** la couche d'arrêt présente une densité surfacique d'atomes dopants comprise entre des densités surfaciques d'atomes dopants maximale et minimale, la densité surfacique maximale d'atomes dopants étant définie comme étant le produit d'une densité surfacique maximale tolérable de dopant à la surface de la zone d'arrêt de queue du côté anode par une longueur caractéristique de décroissance du profil de dopant dans la zone d'arrêt de queue, et **en ce que** la longueur caractéristique de décroissance du profil de dopant est définie par :

$$ L = \frac{x_j}{\ln\left(\dfrac{N_s}{N_0}\right)} $$

où L : longueur caractéristique de décroissance du profil de dopant ;
$X_j$ : distance entre une jonction pn se trouvant entre la zone d'arrêt de queue et l'anode, et un point où la densité de dopant s'est réduite au double de la valeur de la densité de dopant de base ;
$N_s$ : densité surfacique de dopant ; et
$N_0$ : densité de dopant de base ;
la densité surfacique minimale d'atomes dopants étant définie par :

$$ N_{tail,\min} \equiv \frac{E(W_{PT}) * \varepsilon_{si} * \varepsilon_0}{q} $$

où $N_{tail,min}$ = densité surfacique minimale d'atomes dopants ;
$E(W_{PT})$ : champ électrique au niveau d'une jonction pn lors d'un claquage par avalanche ;
$\varepsilon_{si}$ : constante diélectrique de la plaquette ;
$\varepsilon_0$ : permittivité du vide ; et
q : charge de l'électron.

Fig. 1a

Fig. 1b

Fig. 1c

Fig. 1d

Fig. 1e

Fig. 2

Fig. 3

**Fig. 4**

**Fig. 5**

**Fig. 6**

**Fig. 7**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19829614 A

- EP 1017093 A

**In der Beschreibung aufgeführte Nicht-Patentliteratur**

- **Darryl Burns et al.** NPT-IGBT-Optimizing for manufacturability. *IEEE,* 1996, 109-112
- **Andreas Karl.** *IGBT Modules Reach New Levels of Efficiency, PCIM Europe,* 1998, 8-12

- **J. Yamashita et al.** A novel effective switching loss estimation of non-punchthrough and punchthrough IGBTs. *IEEE,* 1997, 331-334